Europäisches Patentamt

European Patent Office

Office européen des brevets

(19)

(11) Veröffentlichungsnummer: **0 179 102 B1**

(12) **EUROPÄISCHE PATENTSCHRIFT**

(45) Veröffentlichungstag der Patentschrift: **01.07.92**

(21) Anmeldenummer: **85901982.0**

(22) Anmeldetag: **25.04.85**

(86) Internationale Anmeldenummer:
**PCT/DE85/00133**

(87) Internationale Veröffentlichungsnummer:
**WO 85/04986 (07.11.85 85/24)**

(51) Int. Cl.⁵: **H01L 31/10,** H01L 27/14

(54) **VERARMTES HALBLEITERELEMENT MIT EINEM POTENTIAL-MINIMUM FÜR MAJORITÄTSTRÄGER.**

(30) Priorität: **25.04.84 DE 3415426**
**25.04.84 DE 3415443**
**19.05.84 DE 3418778**
**25.07.84 DE 3427476**

(43) Veröffentlichungstag der Anmeldung:
**30.04.86 Patentblatt 86/18**

(45) Bekanntmachung des Hinweises auf die
Patenterteilung:
**01.07.92 Patentblatt 92/27**

(84) Benannte Vertragsstaaten:
**AT BE CH DE FR GB IT LI LU NL SE**

(56) Entgegenhaltungen:
**DE-A- 2 606 308**
**DE-A- 2 736 734**
**US-A- 3 858 232**
**US-A- 3 906 543**

(73) Patentinhaber: **KEMMER, Josef**
**Hauptstrasse 41 D**
**W-8048 Haimhausen(DE)**

Patentinhaber: **Lutz, Gerhard, Dr.**
**Therese-Giehse-Allee 23**
**W-8000 München 83(DE)**

(72) Erfinder: **KEMMER, Josef**
**Hauptstrasse 41 D**
**W-8048 Haimhausen(DE)**
Erfinder: **Lutz, Gerhard, Dr.**
**Therese-Giehse-Allee 23**
**W-8000 München 83(DE)**

(74) Vertreter: **Steinmann, Otto C. et al**
**Kanzlei Münich, Steinmann, Schiller Willi-**
**baldstrasse 36**
**W-8000 München 21(DE)**

Philips Technical Review, Band 37, Nr. 11/12, 1977, (Eindhoven, NL) Seiten 303-311 H.Heyns u.a.: "Image sensors with resistive electrodes", Seite 306

Brookhaven National Laboratory, Nr. 33523, August 1983, (New York, US) E.Gatti u.a.: "Semiconductor Drift chamber - An application of a Novel Charge Transfer Scheme" Seiten 3-11

Radio Fernsehen Elektronik, Band 28, Nr. 2, Februar 1979, (Berlin, DD) Seiten 75-78 H. Bergmann: "Halbleiter-Bildaufnahmeeinrichtungen"

Electronics International, Band 55, Nr 8, 21 April 1982, (New York, US) Seiten 141-144 E.F. Rybaczewski: "Virtual-Phase structure simplifies clocking for CCD image sensor"

# Beschreibung

Die Erfindung bezieht sich auf ein Halbleiterelement in dem das Grundgebiet vollständig an Majoritätsträgern verarmt ist und in dem ein Potentialminimum für die Majoritätsträger im Inneren des Grundgebiets verläuft.

Ein derartiges Halbleiterelement für den speziellen Anwendungsfall "Halbleiterdetektor" ist aus der Veröffentlichung von Gatti u.a.: "Semiconductor drift chamber - an application of a novel charge transport scheme", BNL-33523, Brookhaven National Laboratory, August 1983 bekannt. Bei diesem bekannten Detektor, der auch als Halbleiterdriftkammer bezeichnet wird, läßt sich die Position der einfallenden Teilchen über die Driftzeit der Majoritätsträger, also beispielsweise der Elektronen bei einem n-dotierten Halbleiterkörper, in einem elektrischem Transversalfeld bestimmen. Darüberhinaus sind in dieser Veröffentlichung verschiedene Modifikationen dieses Halbleiterdetektors beschrieben: gemäß einer Modifikation läßt sich der Halbleiterdetektor beispielsweise als CCD-Element für die Majoritätsträger verwenden.

Bei dem bekannten Halbleiterdetektor wird der Halbleiterkörper durch von beiden Hauptoberflächen angelegte Vorspannung vollständig verarmt, so daß sich im Inneren des Körpers ein Potentialminimum für die Majoritätsträger befindet, in dem die Majoritätsträger gesammelt und bewegt werden. Den Minoritätsträgern andererseits wird keine Beachtung geschenkt.

Erfindungsgemäß ist nun erkannt worden, daß die Existenz des Potentialminimums für die Majoritätsträger, das gleichzeitig ein Potentialmaximum für die Minoritätsträger darstellt, eine gezielte Beeinflußung der Menge, der Bewegungsrichtung und/oder der Geschwindigkeit der Minoritätsträger erlaubt; hierdurch ergeben sich für erfindungsgemäße Halbleiterelemente gemäß den Ansprüchen 1 bis 23 eine Reihe von zusätzlichen Anwendungsmöglichkeiten.

Durch den Verlauf des Potentialmaximum für die Minoritätsträger wird das Grundgebiet in mehrere für die Minoritätsträger unabhängige Teile auf beiden Seiten der Potentialmaxima geteilt. Dies ermöglicht beispielsweise mit einem vergleichsweise dicken Halbleiterkörper und einem dicht unter einer Hauptoberfläche, in der sich weitere Gebiete befinden, die elektronische Elemente bilden, liegenden Potentialmaximum eine Epitaxieschicht zu simulieren, d.h. man erreicht mit einem vergleichsweise dicken Grundkörper die Vorteile beispielsweise hinsichtlich Grenzfrequenz, Sperrströme etc. einer Epitaxieschicht.

Natürlich ist es durch eine spezielle geometrische Gestaltung auch möglich, in einem Grundgebiet mehrere Potentialmaxima beispielsweise mittels eines Sandwich-Aufbaus-zu erzeugen, bei dem sich p- und n-dotierte Gebiete abwechseln. Ferner ist es auch möglich, eine Zylindergeometrie zu verwenden, bei der das Potentialmaximum in der Zylinderachse verläuft.

Insbesondere dann, wenn das erfindungsgemäße Halbleiterelement als Detektor für Teilchen und/oder Strahlung, wie γ-Strahlung und Röntgenstrahlung, aber auch für Strahlung mit Wellenlängen vom UV bis Infrarot verwendet wird, ist es von Vorteil, daß durch die Aufteilung des Halbleiterkörpers in mindestens zwei für die Minoritätsträger unabhängige Teile an jeder Hauptoberfläche ein Minoritätsträgersignal erzeugt wird, das von in unterschiedlichen Teilen des Halbleiterkörpers gebildeten Minoritätsträgern abgegeben wird, und das in unterschiedlicher Weise weiterverarbeitet werden kann. Beispielsweise kann das an einer Hauptoberfläche des Halbleiterkörpers anstehende Minoritätsträgersignal als Triggersignals für das von den Majoritätsträgern an der Sammelelektrode hervorgerufene Signal dienen. Ferner können die Minoritätsträgersignale auch zur Positions- und/oder zur Energie-und Reichweitenbestimmung der einfallenden Strahlung verwendet werden. Dabei ist es möglich, das Minoritätsträgersignal "schnell" auszulesen oder den erfindungsgemäßen Halbleiterdetektor als CCD-Element für die Minoritätsträgersignale zu verwenden.

Die Bewegungsrichtung und/oder die Geschwindigkeit der Minoritätsträger kann darüberhinaus erfindungsgemäß auch durch den Verlauf des Potentials unter den Hauptoberflächen beeinflußt werden (Anspruch 1). Der Verlauf des Potentials wiederum kann beispielsweise durch die Dotierung (Anspruch 4), die Elektrodengestaltung etc. beeinflußt werden.

Verschiedene Möglichkeiten der Elektrodengestaltung auf den beiden Hauptoberflächen sind in den folgenden Ansprüchen gekennzeichnet. Dabei können Elektrodenanordnungen gemäß einem der Ansprüche auf beiden oder nur auf einer der Hauptoberflächen vorgesehen werden.

Erfindungsgemäß ist es möglich, die Minoritätsträgersignale aus nur einem der durch Potentialmaxima getrennten Gebiete (Anspruch 1), aus mehreren oder aus allen voneinander getrennten Gebieten auszulesen (Anspruch 2).

Ferner ist es möglich, zusätzlich auch das Majoritätsträgersignal auszuwerten, das von den im gesamten Körper gebildeten und im Potentialminimum gesammelten Majoritätsträgern erzeugt wird. Hierzu ist mindestens eine Sammelelektrode für die Majoritätsträger vorzusehen (Anspruch 3).

Besonders vorteilhaft ist die Elektrodengestaltung gemäß Anspruch 5. Durch die erfindungsgemäß vorgesehene RIS-Struktur, d.h. eine Struktur, bei der auf mindestens einer Hauptoberfläche eine Isolationsschicht vorgesehen ist, auf der sich eine leitende Schicht, beispielsweise eine Widerstandsschicht oder eine niederohmige Schicht befindet, wird nicht nur ein Abfließen der Minoritätsträger in die Bereiche der Hauptoberflächen verhindert, sondern es ist auch möglich, beispielsweise ein gegen die Hauptoberflächen "verkipptes" Potential zu erzeugen. Eine derartige RIS-Struktur kann im Grenzfall, wenn die oberste Schicht niederohmig ist, beispielsweise eine MOS-Struktur sein.

Darüberhinaus ermöglicht diese Elektrodenausbildung die Realisierung eines kontinuierlichen CCD-Elements, bei dem das Verschieben der zu der Hauptoberfläche geflossenen Minoritätsträger kontinuierlich erfolgt. Ein derartiges CCD-Element hat den Vorteil, daß die einzelnen Zellen nicht gelöscht werden müssen.

Ferner kann die Elektrodenanordnung nach Anspruch 8 auch eine an sich bekannte Sperrschicht sein, die beispielsweise von pn-Übergängen, Schottky-Übergängen oder heterogenen Strukturen gebildet wird.

Bei einer weiteren Fortbildung der Erfindung gemäß Anspruch 9 wird mindestens eine der als Elektrodenanrdnung verwendeten Sperrschichten und niederohmig ausgebildet. Hierdurch erhält man zum einem ein schnelles Triggersignal, zum anderen wird durch das großflächig ausgeführte Gebiet die Fotolitographie bei der Herstellung vereinfacht.

Gemäß Anspruch 10 bilden bevorzugter Weise pn-Übergänge die Sperrschicht.

Die Anordnungen gemäß Anspruch 11 und 12 haben beispielsweise den Vorteil, daß durch geeignete an die Elektrodenanordnungen angelegte Vorspannungen ein definierter transversaler Potentialgradient erzeugt werden kann. Ferner kann beispielsweise an einem Gebiet des zweiten Leitfähigkeitstyps eine zweite Spannung angelegt werden, die die Durchbruchspannung des pn-Übergangs um ein Vielfaches übersteigt. Hierdurch stellt sich an den benachbarten Gebieten eine Spannung ein, die von einem Gebiet zum Nächsten um jeweils die Durchbruchspannung abnimmt. Auf diese Weise ist es - wie in der älteren Patentanmeldung DE-A- 34 09 163 beschrieben - möglich, mit geringem äußeren Schaltungsaufwand ein genau definiertes transversales elektrisches Feld im Halbleiterkörper einzustellen.

Die streifen-oder matrixförmigen Gebiete gemäß Anspruch 15 erlauben ferner eine Bestimmung beispielweise des Orts der einfallenden Strahlung. Ferner ist beispielsweise bei streifenförmigen Gebieten möglich, diese durch implantierte "Querstreifen" zu verbinden und so einen integrierten Spannungsteiler aufzubauen.

Der zum Aufbau eines transversalen Feldes erforderliche äußere Schaltungsaufwand kann auch dadurch vereinfacht werden, daß z.B. ein Gebiet des zweiten Leitfähigkeitstyps auf mindestens einer der beiden Hauptoberflächen ein großflächiges hochohmiges Gebiet ist; der in diesem Gebiet auftretende Spannungsabfall in Transversalrichtung erzeugt das gewünschte transversale elektrische Feld. Diese Anordnung hat den Vorteil, daß der Justieraufwand bei der Herstellung beträchtlich geringer ist als bei einer Anordnung, bei der sich auf beiden Hauptoberflächen eine Vielzahl voneinander getrennten Gebieten befindet.

Der erfindungsgemäße Halbleiterdetektor hat insbesondere dann, wenn er als CCD-Halbleiterdetektor für die Majoritätsträger betrieben wird, eine Reihe von Vorteilen:

Beispielsweise kann das Minoritätsträgersignal ohne Verzögerung ausgelesen werden, so daß zusätzlich zu dem CCD-Signal der Majoritätsträger ein schnelles Signal zur Verfügung steht, das z.B. als Triggersignal verwendet werden kann.

Eine streifen- oder matrixförmige Ausbildung der Elektroden auf der anderen Hauptoberfläche gestattet darüberhinaus eine Ortsauflösung des von den Minoritätsträgern erzeugten Signals parallel zu der Hauptoberfläche.

Hierdurch wird eine Zuordnung der langsam auslesbaren CCD-Signale zu den schnellen Minoritätsträger-Signalen möglich, die beispielsweise partielles Lesen, d.h. das Überspringen "leerer" CCD-Zellen erlaubt, so daß die Auslesegeschwindigkeit drastisch erhöht werden kann. Ferner können beispielsweise Signale von "unerwünschten" Ereignissen während der Auslesezeit ausgeschieden werden.

In jedem Falle hat das erfindungsgemäße CCD-Halbleiterbauelement die Vorteile, daß das voll depletierte Volumen große Signale für durchlaufende Teilchen bzw. Strahlung ergibt, und daß die Signale dennoch nahe der Oberfläche gespeichert werden.

Die streifen- oder matrixförmige Struktur auf der einen der beiden Hauptoberflächen kann eine RIS-Struktur, insbesondere eine MOS-Struktur, oder eine "Bipolar"-Struktur sein, d.h. sie kann aus pn-Übergängen bestehen. Natürlich können auch Schottky-Übergänge, heterogene Übergänge etc. verwendet werden.

Die Verwendung einer RIS-Struktur oder MOS-Struktur hat den Vorteil, das erfindungsgemäße Halbleiterbauelement als CCD-Element sowohl für die Majoritätsträger als auch für die Minoritätsträger betreiben zu können. Man erhält dadurch zwei "Ladungsbilder". Dabei wird das "Ladungsbild" der Majoritätsträger durch im gesamten Halbleiterkörper erzeugte Majoritätsträger hervorgerufen, während das "Ladungsbild" der Minoritätsträger nur von den Minoritätsträgern erzeugt wird, die durch die einfallende Strahlung zwischen der Hauptoberfläche mit RIS-Struktur und dem Potentialminimum für die Majoritätsträger gebildet werden. Damit erlaubt ein Vergleich der beiden "Ladungsbilder" beispielsweise eine Diskriminierung unterschiedlicher Eindringtiefen. Verwendet man das erfindungsgemäße CCD-Element beispielsweise als Detektor für sichtbares Licht und Infrarotstrahlung und fällt die Strahlung durch die Hauptoberfläche ein, auf der sich die RIS-Struktur befindet, so gibt das Ladungsbild der Majoritätsträger das vom sichtbaren Licht und vom Infrarotlicht erzeugte Bild wieder, während das Ladungsbild der Minoritätsträger im wesentlichen das vom sichtbaren Licht erzeugte Bild wiedergibt.

Das Aufbringen einer Minoritätsträger-CCD-Struktur auf der anderen Hauptoberfläche erlaubt es darüberhinaus, ein drittes Ladungsbild auszulesen. Wobei das gewonnene Minoritätsträgerbild ein Infrarotbild liefert.

Durch die Ausbildung gemäß den Ansprüchen 15 und 16 erhält man beispielsweise bevorzugte Schieberichtungen bei CCD-Elementen.

Ferner ist es möglich, MIS- und Bipolarstrukturen alternierend und in Richtung der Normalen der Hauptoberfläche versetzt anzuordnen; hierdurch können die CCD-Zellen sehr dicht gepackt werden. Diese Anordnung ist darüberhinaus technologisch sehr einfach herzustellen. Das erfindungsgemäße Halbleiterelement erlaubt es darüberhinaus in sehr einfacher Weise, elektronische Strukturen mit in den Halbleiterkörper zu integrieren.

Mögliche Verwendungen der erfindungsgemäßen Halbleiterelemente sind:

- als Grundkörper für elektronische Elemente zum Ersatz einer Epitaxieschicht
- als Single-Photon-Avalanche-Diode
- als Detektor für Teilchen und/oder elektromagnetische Strahlung
- als positionsempfindlicher Strahlungsdetektor für Majoritätsträger vom Driftkammertyp mit internen Trigger
- als positionsempfindlicher Detektor für Minoritätsträger und/oder Majoritätsträger
- als kombinierter Detektor
- als positionsempfindlicher CCD-Detektor
- als CCD-Element für die Majoritätsträger, bei dem die von den Minoritätsträgern erzeugten Signale anderweitig ausgelesen werden
- als CCD-Element für die Majoritätsträger und mindestens für die Minoritätsträger, die zwischen der einen Hauptoberfläche und dem Potentialminimum für die Majoritätsträger erzeugt werden
- als kontinuierliches CCD-Element
- als Strahlungsdetektor mit eingebauter elektronischer Signalverstärkung

Die Erfindung wird nachstehend anhand von Ausführungsbeispielen unter Bezugnahme auf die Zeichnung näher beschrieben, in der zeigen:

Figur 1
einen Querschnitt durch ein erstes Ausführungsbeispiel der Erfindung,
Figur 2
einen Querschnitt durch ein zweites Ausführungsbeispiel der Erfindung,
Figur 3a und b
einen Querschnitt durch ein drittes Ausführungsbeispiel der Erfindung.
Fig. 4
einen Querschnitt durch ein erstes Ausführungsbeispiel der Erfindung bei Verwendung als "kombinierter Halbleiterdetektor",
Fig. 5a und b
einen Querschnitt durch ein zweites Ausführungsbeispiels der Erfindung bei Verwendung als kombinierter Halbleiterdetektor,
Fig. 6
einen Querschnitt durch ein erstes Ausführungsbeispiel der Erfindung bei Verwendung als CCD-Element,
Fig. 7
einen Querschnitt durch ein zweites Ausführungsbeispiel der Erfindung bei Verwendung als CCD-Element,
Fig. 8
einen Querschnitt durch ein Ausführungsbeispiel der Erfindung bei Verwendung als Majoritätsträger-CCD-Element,
Fig. 9
einen Querschnitt durch ein erstes Ausführungsbeibeispiel bei Verwendung als kontinuierliches CCD-Element,
Fig. 10
einen Querschnitt durch ein zweites Ausführungsbeispiel bei Verwendung als kontinuierliches CCD-Element,
Fig. 11
einen Querschnitt durch eine erfindungsgemäße ausgebildete Single-Photon-Avalanche-Diode,
Fig. 12
einen Querschnitt durch ein erstes Ausführungsbeispiel eines erfindungsgemäßen Halbleiterelements mit integrierten elektronischen Strukturen und
Fig. 13a bis 13c
einen Querschnitt durch ein zweites Ausführungsbeispiel mit integrierten elektronischen Strukturen.

Mit den im folgenden erläuterten Ausführungsbeispielen soll exemplarisch für den Anwendungsfall "Halbleiterdetektor" gezeigt werden, daß durch die Kombination verschiedener Elektrodenstrukturen aufbauend auf ein- und demselben Grundgedanken die verschiedensten Halbleiterelemente für unterschiedliche Zwecke realisiert werden können.

In den im folgenden erläuterten Figuren ist mit k jeweils ein Halbleiterkörper bezeichnet, der Zwei Hauptoberflächen 1 und 2 aufweist, und der bei den vorgestellten Ausführungsbeispielen ohne Beschränkung der Allgemeinheit aus hochohmigen homogen n-dotiertem Silizium besteht. Die in den Hauptoberflächen vorgesehenen Gebiete eines zweiten Leitfähigkeitstyps sind p-Gebiete und werden mit p1, p2,... usw. bezeichnet.

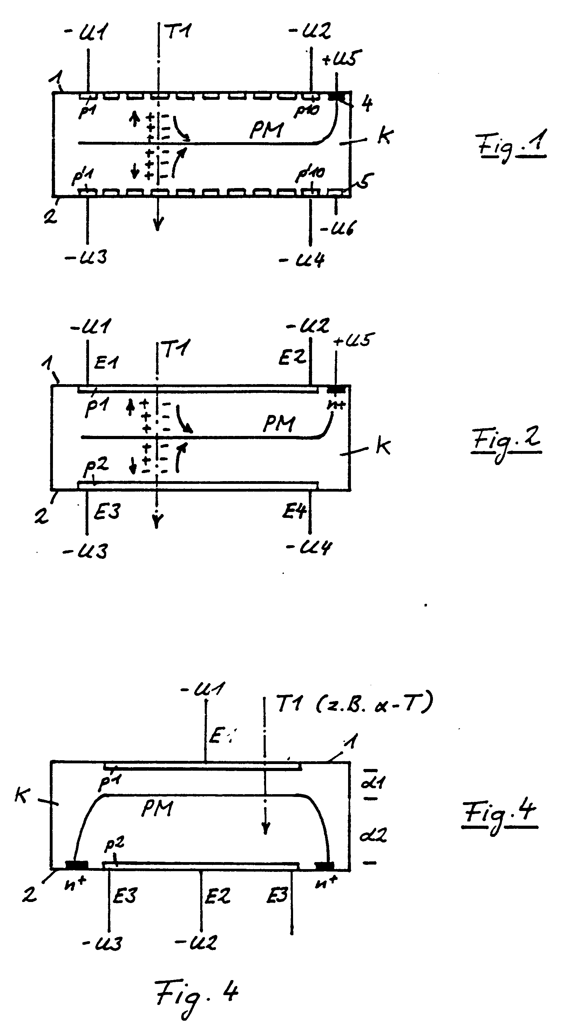

Figur 1 zeigt einen Querschnitt durch einen erfindungsgemäßen Kalbleiterdetektor. Auf der Hauptoberfläche 1 befindet sich eine Vielzahl von p-Gebieten p1... p10,... und auf der Hauptoberfläche 2 eine Vielzahl von p-Gebieten p'1.. p'2,... Ferner befinden sich auf der Hauptoberfläche 1 ein n+-Gebiet 4 und auf der Hauptoberfläche 2 eine p-dotierte Gegenelektrode 5, an der eine Spannung -U6 anliegt, und die den Potentialverlauf "glättet".

An Elektroden auf den p-Gebieten p1, p10, p'1, p'10 sind Spannungen -U1, -U2, -U3 bzw. -U4 angelegt. Die Größe der Spannungen ist so gewählt, daß einerseits ein transversales elektrisches Feld aufgebaut wird, und andererseits der Halbleiterkörper vollständig an Majoritätsträgern, d.h. Elektronen verarmt ist. Dabei besteht folgende Beziehung:

$$U1 > U2 \; , \; U3 > U4 \qquad (^*)$$

Die Elektronen werden dann in einem Potentialminimum, das durch eine Linie PM dargestellt ist, in der Mitte des Halbleiterkörpers gesammelt.

Bei dem gezeigtem Ausführungsbeispiel ist U1 = U3 und U2 = U4 (=0V), so daß sich das Potentialminimum in der Mitte des Halbleiterkörpers befindet.

Ein einfallendes ionisierendes Teilchen T1 erzeugt im Halbleiterkörper Elektronen/Loch-Paare, die schematisch durch + und - Symbole dargestellt sind. Die Elektronen driften entlang des Potentialsminimums PM zu dem n+-Gebiet 4, an dem eine Spannung +U5 anliegt, und das als Anode wirkt. Die Minoritätsträger d.h. die Löcher laufen zu dem p-Kontakten, an denen sie zur Auslösung eines Triggersignals für die Elektronenlaufzeit benutzt werden können.

Bei dem in Figur 1 dargestellten Halbleiterdetektor besteht jedoch die Einschränkung, daß an den Elektroden, die auf den p+-Gebieten aufgebracht sind, anfänglich ein dem von den Löchern erzeugten Signal entgegengesetztes Signal von Elektronen influenziert wird, das das von den Löchern erzeugte Signal sogar kompensieren kann; ein Triggersignal kann trotzdem z. B. durch Bewertung der Signalform abgegriffen werden.

Figur 2 zeigt ein weiteres Ausführungsbeispiel eines erfindungsgemäßen Halbleiterdetektors. Der Halbleiterdetektor weist ebenfalls einen Halbleiterkörper k aus n-Silizium mit zwei Hauptflächen 1 bzw. 2 auf. Auf den beiden Hauptoberflächen sind jedoch keine voneinander getrennten streifen- oder ringförmigen p+-Gebiete aufgebracht, die jeweils voneinander beabstandet sind. Vielmehr befindet sich auf jeder Hauptoberfläche jeweils ein großflächiges p-Gebiet p1 bzw. p2, das vergleichsweise hochohmig nach einem an sich bekannten Implantationsverfahren hergestellt ist, und das damit als Widerstandsschicht dienen kann. An einander gegenüberliegenden Stellen der Gebiete p1 bzw. p2 sind Elektroden E1, E2 bzw. E3, E4 angebracht, an denen Spannungen -U1, -U2, -U3 bzw. -U4 anliegen, die die Beziehung (*) erfüllen. An einem n+-Gebiet n+ in der Hauptoberfläche 1 liegt eine Spannung U5 an.

Der Halbleiterdetektor gemäß Fig.2 hat nicht nur den Vorteil, daß die vergleichsweise komplizierten Elektrodenstrukturen auf den beiden Hauptoberflächen durch großflächige Gebiete ersetzt sind, und damit die Justierung bei der Herstellung vereinfacht wird, sondern auch den Vorteil, daß der Ort der die Erzeugung von Elektronen/Loch-Paaren auslösenden Strahlung außer aus der Elektronendriftzeit auch aus dem Verhältnis der von den Löchern an den Elektroden E1 und E2 bzw. E3 und E4 erzeugten Signale grob bestimmt werden kann. Damit ist es möglich, die Zählrate des Detektors zu erhöhen, da bei zwei kurz aufeinanderfolgenden an unterschiedlichen Orten auftreffenden Teilchen eine Zuordnung der Triggersignale möglich ist.

Ferner ist es möglich, an den Gebieten p1 bzw. p2 mehr als zwei Elektroden anzubringen; hierdurch kann eine zweidimensionale Ortsmessung erreicht werden.

Darüberhinaus kann sowohl bei dem in Figur 1 dargestellten Ausführungsbeispiel als auch bei dem in Figur 2 dargestellten Ausführungsbeispiel aus den von den Löchern hervorgerufenen Signalen auch die Energie der einfallenden Teilchen (entspricht der Menge der erzeugten Ladungen) bestimmt werden.

Fig. 3a und 3b zeigen ein weiteres Ausführungsbeispiel eines erfindungsgemäßen Halbleiterdetektors. Im Gegensatz zu den in den Fig.1 und 2 dargestellten Ausführungsbeispielen sind bei diesem Ausführungsbeispiel nur auf der einen Hauptoberfläche 2 des Halbleiterkörpers k Maßnahmen getroffen, um einen Potentialgradienten zu erzeugen. Auf der Hauptoberfläche 1 des Halbleiterkörpers k befindet sich ein großflächiges p-Gebiet p1, auf dem eine elektrisch gut leitende Schicht, beispielsweise aus Aluminium oder aus ITO (Indium-Zinnoxid) bei optischen Detektoren als Elektrode aufgebracht ist, während sich auf der anderen Hauptoberfläche 2 des Halbleiterkörpers eine Struktur befindet, die ein transversales elektrisches Feld erzeugt.

Bei dem gezeigten Ausführungsbeispiel ist diese Struktur wie bei dem in Fig. 2 dargestellten Ausführungsbeispiel ein p-Gebiet mit einem definierten Flächenwiderstand.

Ferner befindet sich in der Hauptoberfläche 2 ein n + -Gebiet 5, auf dem eine Elektrode E4 aufgebracht ist. Wenn an den Elektroden E1, E2, E3 und E4 die Spannungen -U1, -U2, -U3 = O und + U4 angelegt werden, ergibt sich das in Fig. 3 dargestellte Potentialminimum PM, das von der Hauptoberfläche 1 zu dem $n^+$-Gebiet hin verläuft. Durch dieses Potentialminimum PM wird der Halbleiterkörper k in zwei für die Minoritätsträger (Löcher) unabhängige Gebiete unterteilt. Der Einfallsort und die abgegebene Energie eines Teilchens, das längs seiner Bahn eine konstante Elektronen/Löcher-Dichte erzeugt und den Detektor durchquert, können auf verschiedene Weisen bestimmt werden. Hierbei wird von der Tatsache Gebrauch gemacht, daß der Anteil der Minoritätsträger, der jeweils zur oberen bzw. zur unteren Elektrode wandert, von der Lage des Potentialminimums abhängt. Ein den in Fig. 3a dargestellten Detektor durchfliegendes Teilchen T1 erzeugt im oberen Teil wenig Löcher, im unteren Teil jedoch viele, während für ein Teilchen T2 das Gegenteil der Fall ist.

Es ist damit prinzipiell möglich, aus dem Signalverhältnis der Löcher in beiden Halbleiterteilen die Position des Teilchens zu bestimmen. Erschwert wird die Ortsbestimmung allerdings dadurch, daß in der Anfangsphase der Ladungswanderung die von den Löchern hervorgerufenen Signale durch Influenzsignale der Elektronen, die zum Potentialminimum wandern, überlagert werden. Der Einfluß der Elektronen auf die von den Löchern hervorgerufenen Signale an den p-Elektroden E1, E2 und E3 ist natürlich vom Abstand der Elektronenwolke, d. h. des Potentialminimums von den beiden Elektroden abhängig. Erst wenn die Elektronen die Anode, d. h. die Elektrode E4 erreicht haben, ist der Einfluß verschwunden. Man kann deshalb vorteilhafter Weise die Signalform an den Elektroden E1, E2 und E3 zur Positionsbestimmung heranziehen.

Bei der in Fig.3a dargestellten Lage des Potentialminimums PM überkompensiert beim Teilchen T1 das "Influenzsignal" in der Anfangsphase das "Löchersignal", bei Teilchen T2 jedoch nicht.

Vergrößert man jedoch durch Variation der Spannungen U1, U2 und U3 den Abstand des Potentialminimums PM von der Hauptoberfläche 1 (Fig.3b), so wird das an der Elektrode E1 anstehende schnelle Triggersignal, das von den Löchern erzeugt wird, unmittelbar nach dem Einfall des Teilchens T1 nicht so stark von den "Influenzsignal" überlagert. Man erhält ein positives Signal, wenn das Potentialminimum unterhalb der geometrischen Mitte verläuft. Aus der Amplitude dieses Signals ist direkt der Einfallsort bestimmbar. Durch diese grobe Ortsbestimmung über das Minoritätsträgersignal läßt sich die Zählrate des Detektors erhöhen.

Eine weitere Möglichkeit, den Einfluß der Elektronen zu vermindern, besteht darin, eine Elektrode, beispielsweise die auf der Hauptoberfläche 1 aufgebrachte Elektrode E1 in Form von Streifen senkrecht zur Bildebene auszuführen. Mit dem Wegwandern der Elektronen von dem jeweiligen Streifen vermindert sich der Einfluß der Influenz auf diese Querstreifen.

Verwendet man Streifen parallel zur Bildebene, d.h. Längsstreifen, so kann sofort aus der Signalform an den verschiedenen Streifen erkannt werden, welcher Streifen von der Strahlung getroffen worden ist, d.h. es ist eine zweidimensionale Ortsauflösung möglich.

In beiden Fällen kann jedoch an der niederohmigen Streifenelektrode ein schnelles Triggersignal für die Elektronen abgegriffen werden. Darüberhinaus kann eine zusätzliche Ortsinformation aus dem an den Elektroden E2 und E3 abgegriffenen "Löchersignal" gewonnen werden. Ferner ist es natürlich auch hier möglich, mehr als zwei Elektroden an dem Gebiet p2 anzubringen, so daß eine zweidimensionale Ortsauflösung möglich ist.

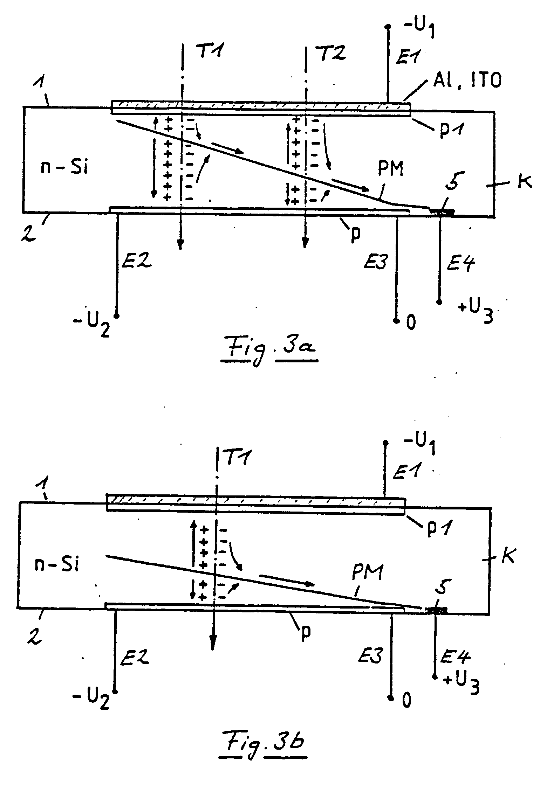

Die Fig. 4 und 5 zeigen als weitere Ausführungsbeispiele einen kombinierten Halbleiterdetektor, beispielsweise einen dE/E-Detektor, der als Diskriminator oder als Spektralanalysator für Licht mit Wellenlängen vom UV bis Infrarot verwendet werden kann. In der Hauptoberfläche 1 befindet sich ein großflächiges niederohmiges p-Gebiet p1 mit einer Elektrode E1 aus Aluminium oder ITO; in einer zweiten Hauptoberfläche 2 befindet sich bei dem Ausführungsbeispiel gemäß Fig. 4 ebenfalls ein großflächiges p-Gebiet p2, das niederohmig oder als Widerstandsschicht ausgeführt sein kann und mindestens zwei Elektrodenanschlüsse E2 und E3 aufweist, wobei E3 E2 ringförmig umschließt.

Ferner befindet sich in der Hauptoberfläche 2 ein ringförmiges $n^+$-Gebiet n +, an der die Spannung U4 ( ≧0) anliegt.

Bei dem Ausführungsbeispiel gemäß Fig. 4 soll angenommen werden, daß die Strahlung durch die Hauptoberfäche 1 einfällt.

Legt man an die Elektrode E1 eine Spannung -U1 und an die Elektrodenanschlüsse E2 und E3 die Spannungen -U2 und -U3 mit -U2 = -U3 an, die groß genug sind, daß sich die Raumladungszonen berühren, so erhält man ein Potentialminimum PM für die Majoritätsträger (bei der exemplarisch gewählten Leitfähigkeit des Grundgebiets die Elektronen), welches bei homogener Dotierung des Halbleiterkörpers durch die geometrische Mitte verläuft.

Wählt man die Spannungen -U1 und -U2 unterschiedlich groß, so liegt das Potentialminimum nicht in der Mitte des Körpers k, sondern ist zu dem mit der niedrigeren Spannung beaufschlagten Gebiet hin verschoben. Bei dem gezeigten Ausführungsbeispiel ist die Spannung U1 kleiner als die Spannung U2, so daß das Potentialminimum näher bei dem Gebiet p 1 liegt.

Durch die zwei für die Minoritätsträger unabhängigen Halbleitergebiete, wie sie sonst nur durch Epitaxie oder Ionenimplantation (buried laver) herstellbar sind, ist in einfacher Weise ein kombinierter Detektor, beispielsweise ein Diskriminator, ein Spektralanalysator, oder wie bei dem in Fig.4 gezeigten Ausführungsbeispiel ein dE/E-Detektor realisierbar. Der zwischen dem Potentialminimum PM und dem Gebiet p1 liegende Teil des Halbleiterkörpers k mit der Dicke d1 stellt den dE-Detektor dar, während der darunterliegende Teil des Körpers k mit der Dicke d2 den E-Detektor ergibt.

Dabei kann die Dicke der beiden Gebiete bzw. Detektoren beliebig durch Änderung der Spannungsverhältnisse und der Dotierung des Halbleiterkörpers, z.B. in Oberflächenrichtung eingestellt werden, d.h. d1 kann auch größer als d2 sein. Die Lage des Potentialminimums, d.h. die Dicken d1 und d2 lassen sich über den Dunkelstrom der Löcher in Abwesenheit von Teilchen bzw. Strahlung ermitteln, wobei evtl. eine zusätzliche Belichtung mit einer Infrarotleuchtdiode erfolgt. Bei Unterteilung der Elektrode E3 z.B. in Form von Streifen ist eine zweidimensionale Ortsauflösung möglich.

Wenn das Gebiet p2 als Widerstandsschicht ausgeführt ist, kann das Verhältnis des an den Elektrodenanschlüssen E2 und E3 abgegriffenen Löcherstroms zusätzlich zu einer Grobbestimmung des Einfallorts dienen.

Im folgenden soll die Funktionsweise des in Fig.4 dargestellten Detektors erläutert werden: Fällt ein Teilchen auf die Hauptoberfläche 1 des dE/E-Detektors ein, so wird es bei genügend großer Reichweite den dE-Detektor vollständig durchqueren und erst im E-Detektor gestoppt werden. Die Menge der im dE-Detektor erzeugten Ladungen (Löcher) liefert den spezifischen Energieverlust, während die Ladungen (Lö-cher) im E-Detektor die Restenergie ergeben. Somit ist es möglich, gleichzeitig die Energie und über den spez. Energieverlust die Art des Teilchens zu bestimmen. Darüberhinaus kann sogar eventuell eine zumindest grobe Information über den Ort des einfallenden Teilchens gewonnen werden. Weiterhin kann die Dicke des dE-Detektors je nach Anwendungsfall leicht verändert werden.

Der in Fig.4 gezeigte Detektor hat den Vorteil, daß keine beispielsweise aus Elektroden bestehenden Totschichten zwischen dem dE-Detektor und dem Detektor zur Bestimmung der Restenergie benötigt werden.

Ferner haben der beschriebene Detektor und auch allgemein entsprechend aufgebaute kombinierte Detektoren den Vorteil, daß die Kapazität der einzelnen Detektoren sehr niedrig ist, da nicht die Dicke eines einzelnen Detektors für die Größe der Kapazität bestimmend ist, sondern die Gesamtdicke (d1 + d2). Damit weist der dE-Detektor ein geringes Rauschen auf. Weiterhin ist der Sperrstrom des dE-Detektors sehr klein, da der sonst sehr kritische Rückkontakt entfällt. Schließlich ist der Detektor unabhängig von der Dicke mechanisch sehr stabil.

In der in Fig.4 gezeigten Form überlagert jedoch wiederum das von den Majoritätsträgern (Elektronen) influenzierte Signal das Minoritätsträgersignal (Löchersignal) im dE-Detektor bei geringem Abstand des Potentialminimums von einer Hauptoberfläche. Es ist deshalb vorteilhaft Maßnahmen vorzusehen, die eine Analyse der Signale, beispielsweise der Signalform ermöglichen, und/oder den Einfluß der Influenz durch Absaugen der Elektronen reduzieren.

Ein vollständiges schnelles Absaugen der Elektronen ist dadurch möglich, daß unmittelbar nach dem Auftreffen eines Teilchens (interner Trigger) das Potentialminimum durch Verkleinern der Spannung U3 gekippt wird. Hierdurch laufen die Elektronen vergleichsweise schnell entlang des Potentialminimums aus dem Bereich der Elektrode E1 in das ringförmige $n^+$-Gebiet. Nachdem diese zum "Herauslaufen" der Elektronen erforderliche Zeit abgewartet worden ist, stellt man den ursprünglichen Zustand (U2 = U3) wieder her und liest die gespeicherte Löcherinformation aus.

Fig. 5 zeigt ein weiteres Ausführungsbeispiel der Erfindung, bei dem der Einfluß der Influenz der Elektronen weitgehend ausgeschaltet ist. Bei dem in Fig. 5 gezeigten Ausführungsbeispiel soll angenommen werden, daß die Strahlung durch die Hauptoberfläche 2 einfällt. Hierbei sind in der Hauptoberfläche 2 abwechselnd Gebiete p1, n2, p3,... vorgesehen, die p- bzw. n-dotiert sind. Die an den Gebieten n2,n4,.... anliegende Spannung U3 ist um einen kleinen Betrag weniger negativ als die Spannung U2, die an den Gebieten p1, p3, ... anliegt: -U3 = -(U2-dU), so daß durch diese Vorspannung des pn-Übergangs in Sperrichtung die Injektion von Majoritätsträgern, d.h. von Elektronen verhindert wird (Fig. 5a).

Zum Beseitigen, d.h. zum schnellen Absaugen der Elektronen im Potentialminimum werden die Spannung U3 oder die Spannungen U3 und U2 gleichzeitig in posiitver Richtung oder/und die Spannung U1 in negativer Richtung verändert. Hierdurch wird das Potentialminimum in Richtung auf die $n^+$-dotierten Gebiete n2, n4,...hin verschoben, so daß die Elektronen im Potentialminimum in die $n^+$-Gebiete fließen können (Fig.5b). Das Elektronensignal kann zur Bestimmung der Gesamtenergie benutzt werden.

Ferner können die Elektronen im Potentialminimum auch dadurch rasch abgesaugt werden, daß die Spannungen U1, U2 und U3 vorübergehend so verändert werden, daß sich die Raumladungszonen nicht mehr berühren, d.h. das Potentialminimum verschwindet und eine dünne n-Schicht entsteht.

Bei einer weiteren Betriebsart kann die Konzentration der Elektronen im Potentialminimum PM beispielsweise durch eine zusätzliche Belichtung so gesteigert werden, daß eine elektrisch gut leitende Schicht entsteht, die die beiden Teile des Halbleiters trennt. Auch hier ist allerdings eine höhere Kapazität die Folge.

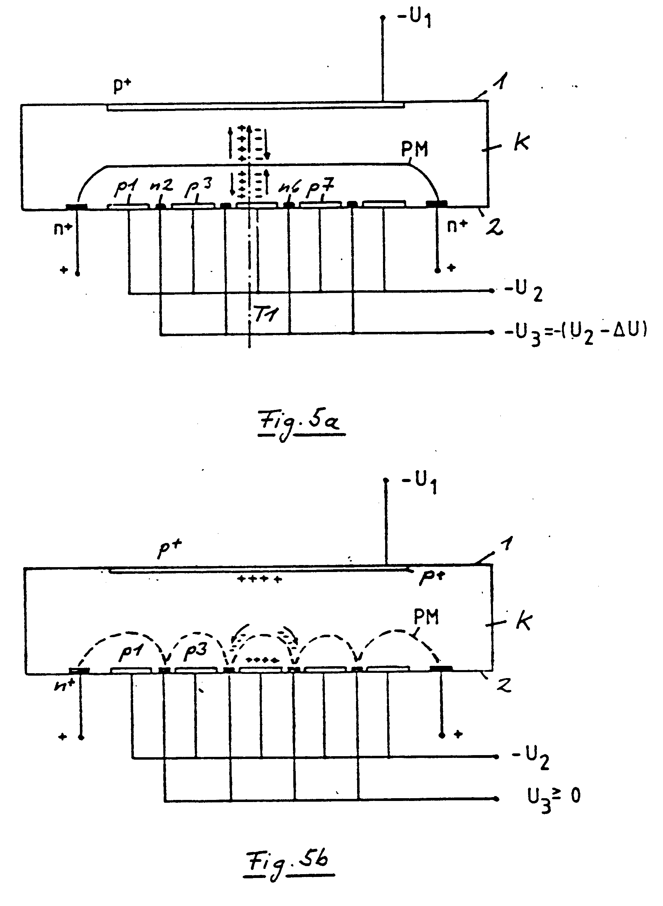

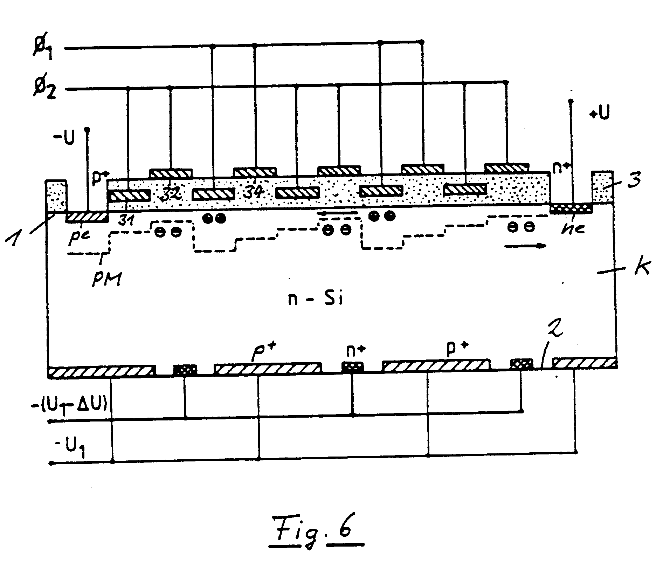

Fig. 6 zeigt einen Querschnitt durch ein erfindungsgemäßes voll depletiertes CCD-Halbleiterbauelement. Das CCD-Element weist wiederum einen n-leitenden Halbleiterkörper k auf, auf dessen Hauptoberfläche 1 sich eine CCD-Struktur und auf dessen Hauptoberfläche 2 sich eine Gegenelektrodenstruktur befindet, die ein schnelles Auslesen der Minoritätsträgersignale und Löschen der Signale beider Ladungsträgerarten gestattet, um ein " Vollaufen" der CCD-Zellen zu verhindern.

Die CCD-Struktur auf der Hauptoberfläche 1 besteht in an sich bekannter Weise aus alternierend in Richtung der Oberflächennormalen versetzt angeordneten Elektroden 31, 32, ... in bzw. auf einer Oberflächenoxidschicht 3 (MOS-Elektroden). An die Elektroden 31, 32, ... werden taktweise sich ändernde Spannungen Ø1 und Ø2 angelegt, die ein Verschieben der Majoritätsträger (Elektronen) und der Minoritätsträger (Löcher) in jeweils entgegengesetzter Richtung zu Leseelektroden ne bzw. pe gestatten, an die Auslesespannungen +U bzw. -U angelegt sind. Zur Erhöhung der Transferefficiency kann eine bekannte "buried-channel"-Anordnung benutzt werden.

Die taktweise Variation der angelegten Spannungen ist bekannt, so daß auf sie im vorliegenden Falle nicht näher eingegangen werden muß. Im Gegensatz zu den bekannten CCD-Elementen ermöglicht jedoch die an sich bekannte zwei- oder mehrphasige Variation der Spannung das gleichzeitige Verschieben sowohl der Majoritätsträger als auch der Minoritätsträger in entgegengesetzter Richtung zu den jeweiligen Ausleseelektroden ne bzw. pe.

Auf der zweiten Hauptoberfläche 2 des Halbleiterkörpers k befindet sich eine streifenförmige Struktur, die alternierend aus p+ und n+ -dotierten Gebieten besteht. durch diese Struktur wird zum einen die vollständige Verarmung des Körper k an Majoritätsträgern möglich. Zum anderen gestatten die $p^+$-Gebiete das schnelle Auslesen der Minoritätsträger, die in dem Teil des Körpers k zwischen der Hauptoberfläche 2 und dem Potentialminimum für die Majoritätsträger beispielsweise durch einfallende Strahlung erzeugt worden sind.

Die zwischen den $p^+$-Gebieten angeordneten $n^+$-Gebiete gestatten zum Löschen der CCD-Zellen das schnelle Absaugen der gespeicherten Majoritätsträger. Hierzu ist normalerweise die Spannung -(U-dU) geringfügig weniger negativ als die Spannung -U, so daß durch diese Vorspannung des pn-Übergangs in Sperrichtung die Injektion von Majoritätsträgern verhindert wird. Zum schnellen Absaugen der Elektronen wird die Spannung (-U-dU) kurzzeitig auf den Wert 0 oder einen Wert größer Null angehoben, so daß die Elektronen in die n+-Gebiete fließen können. Ansonsten kann sinngemäß auch wie vorstehend in Verbindung mit Fig.5 beschrieben verfahren werden. Das in Fig. 6 gezeigte Ausführungsbeispiel erlaubt die Aufnahme von zwei Ladungsbildern. Verwendet man das Element gemäß Fig. 6 beispielsweise als Detektor für sichtbares und Infrarotlicht, so gibt das Minoritätsträger-Ladungsbild, das nur von den im Bereich zwischen der Hauptoberfläche 1 und PM erzeugten Minoritätsträgern hervorgerufen wird, das "sichtbare Bild", da die Eindringtiefe von Licht mit Wellenlängen im sichtbaren Bereich kleiner ist als die von Licht mit Wellenlängen im Infrarotbereich, während das Majoritätsträger-Ladungsbild, das von den im gesamten Körper k erzeugten Majoritätsträgern hervorgerufen wird, das "Mischbild" aus Licht mit Wellenlängen vom Infrarotbereich bis zum sichtbaren Bereich wiedergibt.

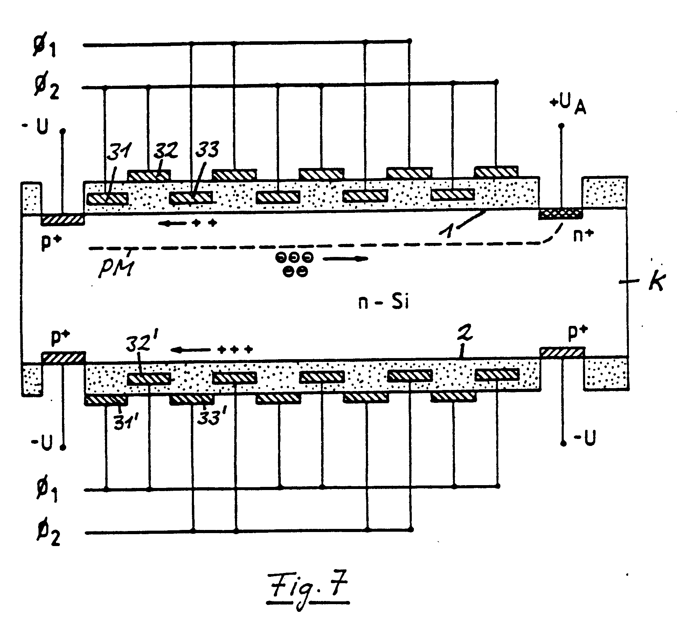

Fig. 7 zeigt ein weiteres Ausführungsbeispiel der Erfindung, bei dem sich auch auf der Hauptoberfläche 2 eine Minoritätsträger-CCD-Strukturbefindet, die in gleicher Weise wie die in Verbindung mit Fig. 6 erläuterte Struktur auf der Hauptoberfläche 1 aufgebaut ist. Lediglich die Elektrode n+ zum Absaugen der Majoritätsträger entfällt, da diese an der Hauptoberfläche 1 gesammelt werden. Die zweite vorgesehene Elektroden p+ ruft einen gewissen Abstoßeffekt hervor, durch den das Fließen der Majoritätsträgr zu der Sammelelektrode für die Majoritätsträger unterstützt und der Verlauf des Potentialminimus "geglättet" wird.

Dieses Ausführungsbeispiel erlaubt die Aufnahme von drei Ladungsbildern, von denen zwei den beiden Ladungsbildern des Ausführungsbeispiels gemäß Fig. 6 entsprechen, und das dritte Ladungsbild von den unter der Hauptoberfläche 2 gesammelten Minoritätsträgern hervorgerufen wird, die im Bereich zwischen der Hauptoberfläche 2 und PM gebildet worden sind.

Das dritte Ladungsbild gibt - wiederum bei Bestrahlung mit Licht mit Wellenlängen vom Infrarot bis zum sichtbaren Bereich, das reine "Infrarotbild", da die gesammelten Minoriträger ausschließlich von Licht mit Wellenlägen im Infrarotbereich erzeugt worden sind.

In den in den Fig. 6 und 7 gezeigten Ausführungsbeispielen sind die verschiedensten Merkmale kombiniert, von denen natürlich zur Realisierung des erfindungsgemäßen Grundgedankens nur ein Teil erforderlich ist. Ferner ist es möglich, die MIS-Elektroden zum Teil oder vollständig z.B. durch pn-Übergänge zu ersetzen.

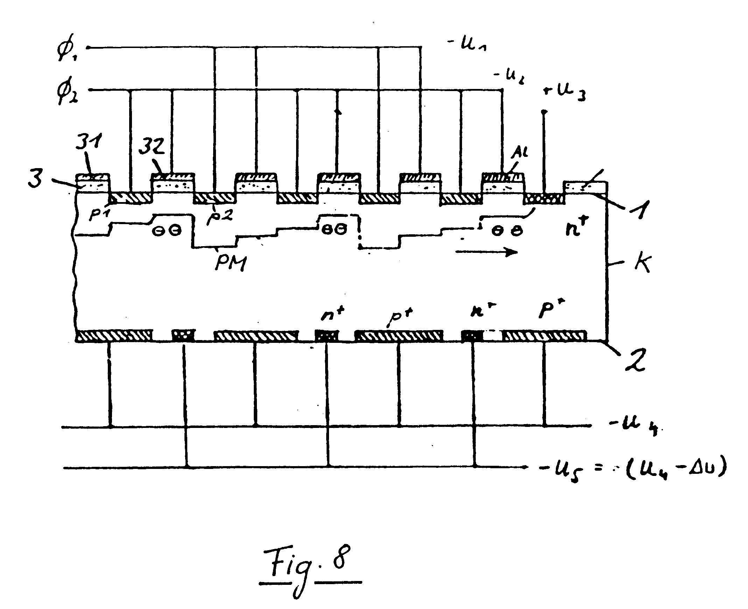

Fig. 8 zeigt ein derartiges CCD-Element, bei dem ein Teil der MIS-Elektroden durch pn-Übergänge ersetzt ist. Bei diesem Ausführungsbeispiel befinden sich auf der Hauptoberfläche 1 abwechselnd p-Gebiete p1,p2..und MOS-Strukturen 31, 32....., d.h. auf einer $SiO_2$-Oxidschicht 3 aufgedampfte Aluminiumschichten Al. Die Struktur auf der Hauptoberfläche 2 entspricht der Elektrodenanordnung bei dem in Verbindung mit Fig. 6 vorgestellten Ausführungsbeispiel.

Bei dem CCD-Element gemäß Fig. 8 können lediglich die Majoritätsträger, die im Potentialminimum PM gesammelt werden geschoben werden, die Signale der Minoritätsträger, die zu den p-dotierten Gebieten wandern, werden anderweitig, beispielsweise über die Struktur auf der Hauptoberfläche 2 ausgelesen.

Ferner ist es bei einem derartigen CCD-Element möglich, durch geeignete Dotierung eine Vorzugsrichtung für das Schieben "einzubauen".

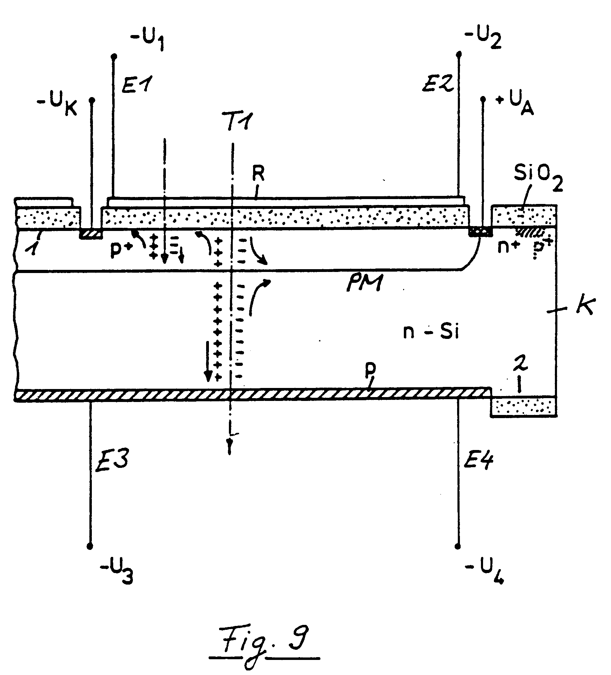

Fig.9 zeigt ein weiteres Ausführungsbeispiel, das in die verschiedenen Vorteile der vorstehend aufgeführten Ausführungsbeispiele vereint.

Auf der Hauptoberfläche 1 des Halbleiterkörpers k befindet sich eine Oxidschicht $SiO_2$, auf der eine Widerstandsschicht R aufgebracht ist. Die Widerstandsschicht R ist mit zwei Elektroden E1 und E2 kontaktiert. Ferner befindet sich in der Hauptoberfläche 1 ein Gebiet p+ zum Sammeln der Minoritätsträger und ein Gebiet n+ zum Sammeln der Majoritätsträger. In der Hauptoberfläche 2 befindet sich ein hochohmiges Gebiet p, d.h.eine Widerstandsschicht, die mit Elektroden E3 und E4 kontaktiert ist.

Legt man an die Elektroden E1 bis E4 Spannungen U1 bis U4 an, die die in Verbindung mit der Beschreibung zu Fig.1 angegebene Beziehung (*) erfüllen, sowie an die Gebiete p+ und n+ die Spannung -UK und +UA, so erhält man einen kontinuierliches CCD-Element für die Majoritätsträger sowie die Minoritätsträger, die zwischen der Hauptoberfläche 1 und PM gebildet werden.

Durch eine $p^+$-Schicht, die angrenzend an das $n^+$-Gebiet in der Hauptoberfläche 1 angeordnet ist, läßt sich die Kapazität der durch das $n^+$-Gebiet gebildeten Elektrode herabsetzen.

Dieses Element hat eine Reihe von Vorteilen:

Eine Positionsbestimmung von einfallenden Teilchen ist sowohl aus dem Majoritätsträger- als auch aus dem Minoritätsträger-Ladungsbild möglich.

- An der Hauptoberfläche 2 steht ein schnelles Triggersignal zur Verfügung, das Verhältnis der an den Elektroden E3 und E4 abgegriffenen Signale kann darüberhinaus zu einer groben Positionsbestimmung der einfallenden Strahlung verwendet werden kann.

- Die Ausleseelektroden haben sowohl für Majoritätsträger als auch für Minoritätsträger eine geringe Kapazität, die sich für das Majoritätsträgersignal durch eine zusätzliche $p^+$-Schicht weiter herabsetzen läßt; ferner fließt ein niedriger Leckstrom.

- Durch die kontinuierliche Verschiebung der Majoritätsträger und der Minoritätsträger ist Löschen "vollgelaufener Zellen" nicht erforderlich.

- Das Element ist als dE/E-Detektor verwendbar und erlaubt die Unterscheidung von gering und tief eindringender Strahlung

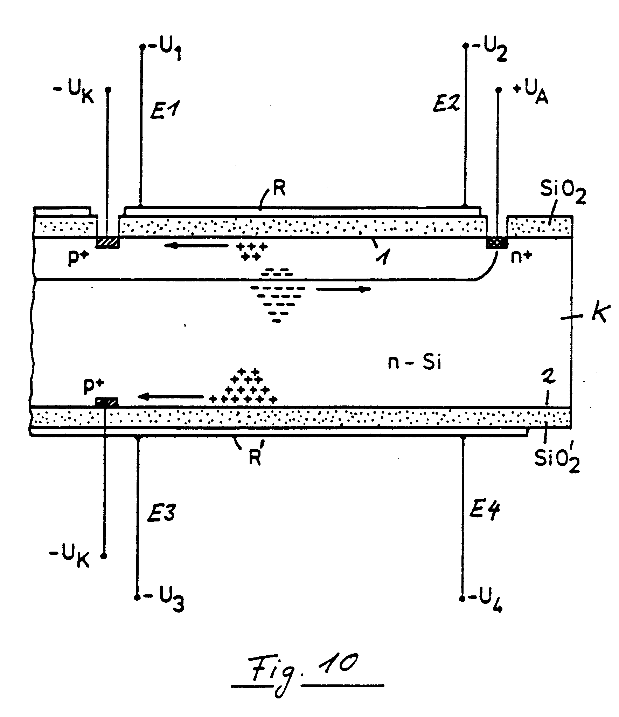

Fig. 10 zeigt eine Modifikation des in Fig. 9 gezeigten Ausführungsbeispiels, bei dem auch auf der Hauptoberfläche 2 eine Minoritätsträger-CCD-Struktur vorgesehen ist. Auf einer Isolationsschicht $SiO_2$' befindet sich wiederum eine Widerstandsschicht R', die über zwei Elektroden E3 und E4 kontaktiert ist, an die Spannungen U3 und U4 angelegt sind, die ebenfalls die Beziehung (*) erfüllen können. Ferner befindet sich in der Hauptoberfläche 2 ein Gebiet p+', an das die Spannung -UK angelegt ist, und in dem die Minoritätsträger gesammelt werden, die zwischen der Hauptoberfläche 2 und PM gebildet werden.

Das in Fig. 10 gezeigte Ausführungsbeispiel liefert wie das CCD-Element nach Fig. 7 drei Ladungsbilder, die beispielsweise dann, wenn das Element als Detektor für sichtbares Licht und Infrarotlicht verwendet wird, unterschiedliche Informationen ergeben.

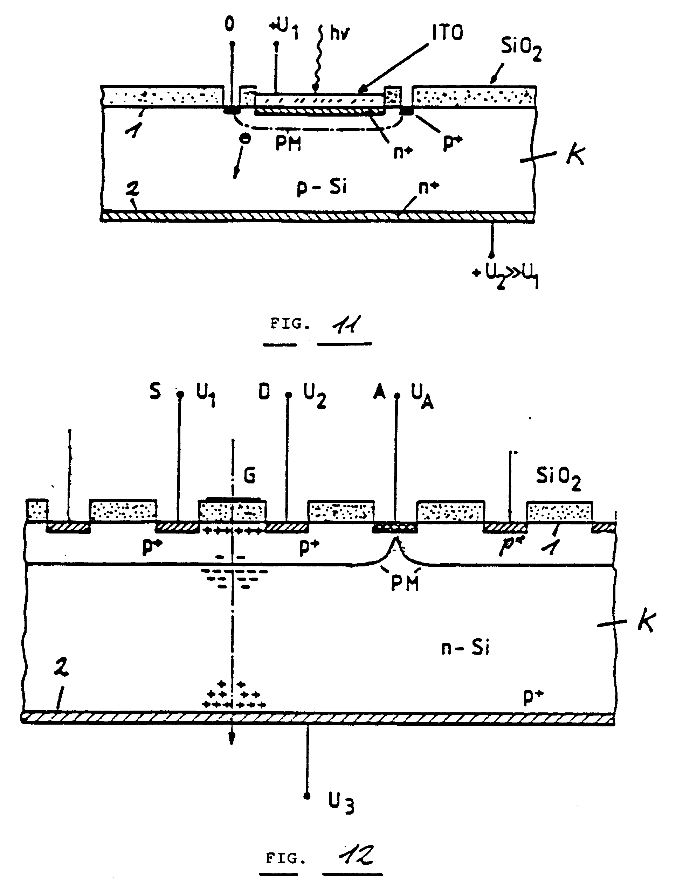

Fig. 11 zeigt als weiteres Ausführungsbeispiel eine nach dem erfindungsgemäßen Prinzip aufgebaute Single-Photon-Avalanche-Diode. Die Diode weist wiederum einen Halbleiterkörper k auf, der bei dem gezeigten Ausführungsbeispiel aus p-dotiertem Silizium besteht. Auf der Hauptoberfläche 1 befindet sich eine Isolationsschicht $SiO_2$ aus Siliziumdioxid, in der sich ein "Fenster" aus ITO befindet. Unter dem Fenster befindet sich in der Hauptoberfläche 1 ein $n^+$-Gebiet n+, das von einem p-dotiertem Verarmungsgebiet p⊕ umgeben ist. Auf der Rückseite befindet sich ein großflächiges niederohmiges $n^+$-Gebiet. An die einzelnen Gebiete sind die in Figur 11 dargestellten Spannungen angelegt, für die gilt:

$$U_2 \gg U_1$$

Aufgrund dieser Beziehung und geeigneter Dotierungsprofile befindet sich das Potentialminimum PM nahe der Hauptoberfläche 1. Das Potentialminimum schirmt damit die Elektronen, die in diesem Falle die Minoritätsträger sind, aus dem größten Teil des Halbleiterkörpers ab, so daß diese keinen unerwünschten Avalanche auslösen können.

Fig. 12 zeigt einen Detektor mit integrierten Feldeffekttransistoren, wobei für gleiche Elemente wie in den vorigen Figuren die gleichen Bezugszeichen verwendet werden. Der Körper k besteht bei diesem Ausführungsbeispiel wieder aus n-dotiertem Silizium. Die mit S, D und G bezeichneten Elemente bilden die Source, die Drain bzw. das Gate des Feldeffekttransistors. Durch die an das Gebiet $p^+$ angelegte Spannung $U_1$, $U_2$ usw. sowie die an der Hauptoberfläche 2 angelegte Spannung $U_3$ wird im Halbleiterkörper wiederum ein Potentialminimum PM erzeugt. Die im Potentialminimum gesammelten Elektronen verändern das Oberflächenpotential im Kanal unter dem Gate G des Feldeffekttransistors, an dessen Source die Spannung $U_1$ und an dessen Drain die Spannung $U2$ anliegen und steuern so den Drainstrom $I_D$. Durch Anlegen einer positiven Spannung $U_1$ an das mit A bezeichnete $n^+$-Gebiet können die Majoritätsträger abgesaugt werden. Die in Fig.12 gezeigte Halbleiteranordnung, bei der die direkt unter dem Gate G erzeugten bzw. gesammelten Ladungen zerstörungsfrei gemessen werden können, ist nur eine von vielen Möglichkeiten, Halbleiteranordnungen "mit eingebauter Signalverarbeitung" zu realisieren. Beispielsweise läßt sich die Ankoppelung des Signals durch Potentialverschiebung an das Gate eines Feldeffekttransistors auch bei einer als Driftkammer betriebenen Halbleiteranordnung verwenden.

Eine Anordnung, bei der der Halbleiterkörper zwischen dem Potentialminimum und der Hauptoberfläche 2 nicht notwendigerweise als Strahlungsdetektor benutzt wird, kann in vorteilhafterweise als Ersatz einer Epitaxieschicht dienen. Halbleiterelemente, wie Transistoren, die ähnlich wie in Fig. 12 in die Hauptoberfläche 1 eingebaut sind, werden durch das Potentialminimum vom restlichen Halbleiterkörper "isoliert", da im Potentialminimum die Majoritätsträger gesammelt werden, und die Minoritätsträger durch das Potentialminimum für die Majoritätsträger, das für die Minoritätsträger ein Potentialmaximum darstellt, aus dem Gebiet zwischen dem Potentialmaximum und der Hauptoberfläche 2 zu der Hauptoberfläche 2 abfließen. Damit verhalten sich die eingebauten Halbleiterelemente, beispielsweise die Transistoren ähnlich wie Elemente, die in einer Epitaxieschicht eingebaut sind. Sie weisen damit die gleichen Vorteile wie derartige Elemente auf, also z.B. hohe Geschwindigkeit der Signalverarbeitung in Folge kleiner Kapazitäten.

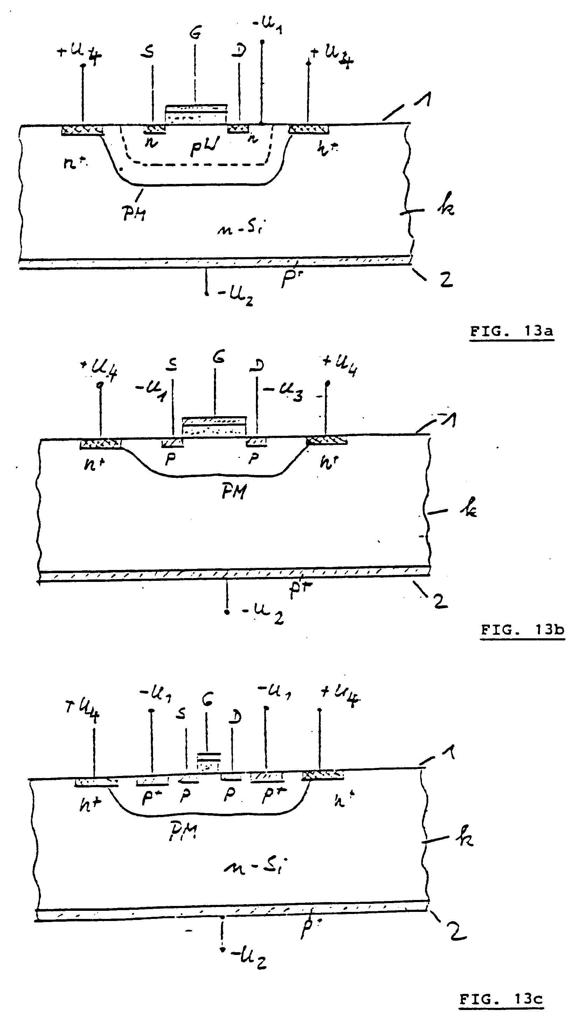

Drei Möglichkeiten der Isolation sind in den Fig. 13a bis c dargestellt.

Bei allen in den Fig. 13a bis c dargestellten Ausführungsbeispielen besteht der Körper k aus n-dotiertem Silizium. In der Hauptoberfläche 2 befindet sich ein niederohmiges Gebiet $p^+$, an das - wie vorstehend bereits mehrfach beschrieben - eine Spannung $-U_2$ angelegt ist, die zusammen mit einer an eine Elektrode in der Hauptoberfläche 1 angelegten Spannung $-U_1$ das Potentialminimum PM für die Majoritätsträger, d.h. bei dem gezeigten Ausführungsbeispielen die Elektronen erzeugt. Ferner befindet sich bei dem Ausführungsbeispiel gemäß Fig. 13a in der Hauptoberfläche 1 eine p-dotierte Wanne pW. Diese Wanne umgibt ein ringförmiges Gebiet $n^+$, an das eine Spannung $U_4$ zum Absaugen der im Potentialminimum PM gesammelten Majoritätsträger angelegt ist.

In Fig. 13 a ist ein für CMCS-Schaltungen wichtiger komplimentärer NMOS-Feldeffekttransistor in der p-Wanne pW dargestellt. Der Feldeffekttransistor weist in an sich bekannter Weise eine n-dotierte Source S und n-dotierte Drain D auf, zwischen denen das Gate G auf einer Isolationsschicht angeordnet ist. Da die Wanne pW durch das Potentialminimum PM für die Majoritätsträger, das ein Potentialmaximum für die Minoritätsträger ist, elektrisch vom Grundkörper k "isoliert ist", werden sowohl die Majoritätsträger, die im Potentialminimum PM gesammelt werden, als auch die Minoritätsträger aus dem "bulk", d.h. dem Hauptteil des Grundkörpers k von der Wanne ferngehalten und umgekehrt. Durch diese elektrische "Isolation" der Wanne werden unerwünschte parasitäre Transistoren und insbesondere der CMOS-Schaltungen gefährlich parasitäre Thyristor vermieden. Die Schaltungen können deshalb gegen den "latch up-Effekt" sicher gemacht werden.

Fig. 13b und 13c zeigen die "Isolationsmöglichkeit" eines PMOS-Feldeffekttransistors in einem n-dotierten Siliziumsubstrat k durch das Potentialminimum PM, das bei dem in Fig. 13b gezeigten Ausführungsbeispiel durch mit negativen Spannungen $-U_1$ und $-U_3$ beaufschlagten Drain- und Source-Elektroden D bzw. S selbst erzeugt wird. In Fig. 13c übernehmen diese Aufgabe zusätzliche mit der Spannung $-U_1$ beaufschlagte $p^+$-Gebiete, zwischen die der Transistor eingebaut ist.

Vorstehend sind Ausführungsbeispiele beschrieben worden. Selbstverständlich sind im Rahmen der Patentansprüche Modifikationen möglich: Beispielsweise können ohne weiteres n- und p-dotierte Gebiete sinngemäß vertauscht oder eine Zylindergeometrie verwendet werden. Ebenso ist es möglich, in Halbleitern mit mehreren alternierenden angeordenten p-,n-,p-dotierten Gebieten sinngemäß mehrere Potentialminima zu erzeugen.

Darüberhinaus kann der Verlauf des Potentialminimums, der außer von der Spannung auch von der Dotierung des Halbleiterkörpers abhängig ist, dazu dienen, Dotierungsunterschiede, z.B. Änderungen des Widerstandes und/oder des Dotierungsprofils zu ermitteln. Daneben ist es auch möglich Effekte wie Rekombination, Trapping oder die Lebensdauer von Ladungsträgern zu untersuchen. Die Lage des Potentialminimums läßt sich beispielsweise aus dem Verhältnis der Dunkelströme der Minoritätsträger ermitteln.

**Patentansprüche**

1. Halbleiterelement mit einem Grundgebiet eines Leitfähigkeitstyps, auf dessen Hauptoberflächen Elektrodenanordnungen vorgesehen sind, und an das von wenigstens einer Elektrodenanordnung auf mindestens einer Hauptoberfläche eine Vorspannung angelegt ist, die das Grundgebiet vollständig an Majoritätsträgern verarmt und ein Potentialminimum für die Majoritätsträger erzeugt, das wenigstens teilweise im Inneren des Grundgebiets verläuft, und in dem die Majoritätsträger gesammelt und zu wenigstens einer Elektrode für die Majoritätsträger bewegbar sind, bei dem auf wenigstens einer Hauptoberfläche mindestens eine Sammelelektrode für die Minoritätsträger, über die das Minoritätsträgersignal ausgelesen wird, vorgesehen ist, und bei dem wenigstens auf der Seite des Potentialminimums für die Majoritätsträger, auf der die Sammelelektrode für die Minoritätsträger vorgesehen ist, die Menge, die Bewegungsrichtung und/oder die Geschwindigkeit der Minoritätsträger durch den Verlauf des Potentialminimums bzw. durch die in dem Potentialminimum gesammelten Majoritätsträger unabhängig von den Minoritätsträgern auf der anderen Seite des Potentialminimums gesteuert werden.

2. Halbleiterelement nach Anspruch 1, dadurch **gekennzeichnet**, daß auf jeder Hauptoberfläche (1,2) Sammelelektroden für die Minoritätsträger vorgesehen sind.

3. Halbleiterelement nach einem der Ansprüche 1 oder 2, **gekennzeichnet** durch mindestens eine Sammelelektrode (n + ) für die Majoritätsträger.

4. Halbleiterelement nach einem der Ansprüche 1 bis 3, dadurch **gekennzeichnet**, daß die Dotierung des Grundgebietes (k) im Bereich mindestens einer Hauptoberfläche (1,2) zum Einstellen des Verlaufs des Potentialminimums (PM) definiert verändert ist.

5. Halbleiterelement nach einem der Ansprüche 1 bis 4, dadurch **gekennzeichnet**, daß die Elektrodenanordnung oder ein Teil derselben auf mindestens einer der Hauptoberflächen (1,2) eine Isolationsschicht ($SiO_2$) ist, auf der eine leitende Schicht (p..;R) mit einem definierten Flächenwiderstand aufgebracht ist.

6. Halbleiterelement nach Anspruch 5, dadurch **gekennzeichnet**, daß die leitende Schicht eine Widerstandsschicht ist.

7. Halbleiterelement nach Anspruch 5, dadurch **gekennzeichent**, daß die leitende Schicht niederohmig ist.

8. Halbleiterelement nach einem der Ansprüche 1 bis 7, dadurch **gekennzeichnet**, daß die Elektrodenanordnung oder ein Teil derselben auf mindestens einer der beiden Hauptoberflächen (1,2) eine Sperrschicht (P) mit einem definierten Flächenwiderstand ist.

9. Halbleiteranordnung nach Anspruch 8, dadurch **gekennzeichnet**, daß der Flächenwiderstand niederohmig ist.

10. Halbleiterelement nach Anspruch 8 oder 9, dadurch **gekennzeichnet**, daß mindestens ein Gebiet eines zweiten Leitfähigkeitstyps zusammen mit dem Grundgebiet die Sperrschicht bildet.

11. Halbleiterelement nach einem der Ansprüche 1 bis 10, dadurch **gekennzeichnet**, daß eine Vielzahl von voneinander getrennten Sperrschichten und/oder Widerstand/Isolator/Halbleiterstrukturen die Elektrodenanordnung bildet.

12. Halbleiterelement nach einem der Ansprüche 1 bis 11, dadurch **gekennzeichnet**, daß die Elektrodenanordnungen matrix- oder streifenförmig angeordnet sind.

13. Halbleiterelement nach einem der Ansprüche 1 bis 12, bei dem auf einer Hauptoberfläche eine Elektrodenanordnung gemäß einem dieser Ansprüche vorgesehen ist, dadurch **gekennzeichnet**, daß auf der anderen Hauptoberlfäche eine Struktur vorgesehen ist, die in an sich bekannter Weise als Minoritätsträger-CCD betreibbar ist.

**14.** Halbleiterelement nach einem der Ansprüche 12 oder 13, dadurch **gekennzeichnet**, daß zwischen den streifen- oder matrixförmigen Elektroden auf der einen Hauptoberfläche Löschelektroden zum Absaugen der Majoritätsträger vorgesehen sind.

**15.** Halbleiterelement nach einem der Ansprüche 12 bis 14, dadurch **gekennzeichnet**, daß die Elektrodenanordnung auf der einen Hauptoberfläche Streifen eines zweiten Leitfähigkeitstyps sind, zu denen senkrecht in der Hauptoberfläche Streifen mit dem selben Leitfähigkeitstyp wie die des Halbleiterkörpers verlaufen.

**16.** Halbleiterelement nach einem der Ansprüche 12 bis 15, dadurch **gekennzeichnet**, daß die streifenförmige oder matrixförmige Struktur auf der einen Hauptoberfläche aus alternierenden und in Richtung der Flächennormale versetzt und gegeneinander angeordneten Widerstand/Isolator/Halbleiterstrukturen und Sperrschichten besteht.

**17.** Halbleiterelement nach einem der Ansprüche 2 bis 16, dadurch gekennzeichnet, daß die Sammelelektrode für die Majoritätsträger ein Anreicherungsgebiet des gleichen Leitfähigkeitstyps wie der des Halbleiterkörpers ist.

**18.** Halbleiterelement nach einem der Ansprüche 2 bis 17, dadurch **gekennzeichnet**, daß , zur Erniedrigung der Kapazität der Sammelelektrode für Majoritätsträger, angrenzend an die Sammelelektrode, ein Verarmungsgebiet des zum Leitfähigkeitstyp des Halbleiterkörpers entgegengesetzten Leitfähigkeitstyps angeordnet ist.

**19.** Halbleiterelement nach Anspruch 18, dadurch **gekennzeichnet**, daß zumindest Teile der Elektrodenanordnung auf mindestens einer der Hauptoberflächen "wannenförmige" Gebiete mit einem zum Leitfähigkeitstyp des Halbleiterkörpers entgegengesetzten Leitfähigkeitstyp aufweisen.

**20.** Halbleiterelement nach einem der Ansprüche 1 bis 19, dadurch **gekennzeichnet**, daß die Elektrodenanordnung zur Erzeugung des Potentialminimums für die Majoritätsträger auf mindestens einer der Hauptoberflächen gleichzeitig als Teil von elektronischen Elementen und insbesondere als Source und Drain von Feldeffekttransistoren dient.

**21.** Halbleiterelement nach einem der Ansprüche 1 bis 20, dadurch **gekennzeichnet**, daß zwischen die Elektrodenanordnung auf mindestens einer der beiden Hauptoberflächen wenigstens ein Gebiet eingeschoben ist, das Teil eines elektronischen Elements ist.

**22.** Halbleiterelement nach einem der Ansprüche 1 bis 21, dadurch **gekennzeichnet**, daß durch übereinander oder nebeneinander angeordnete Gebiete unterschiedlicher Dotierung und/oder Heterostrukturen mehrere Potentialminima vorhanden sind.

**23.** Halbleiterelement nach Anspruch 21 oder 22, dadurch **gekennzeichnet**, daß das Majoritäts- und/oder Minoritätsträgersignal an die eingeschobenen Gebiete durch Influenz angekoppelt wird.

**Claims**

**1.** Semiconductor element having a basic zone of one conductivity type, comprising main surfaces provided with electrode arrays, with a bias voltage being applied by at least one of said electrode arrays on at least one main surface of the element so as to deplete said basic zone completely of majority carriers and to generate a potential minimum for said majority carriers, which minimum extends, at least in part, inside said basic zone and in which said majority carriers are collected and may be moved to at least one electrode for said majority carriers, wherein on at least one main surface at least one collector electrode is provided for the minority carriers, for reading out the minority carrier signal therethrough, and wherein at least on that side of the potential minimum for the majority carriers on which said collector electrode for said minority carriers is provided the quantity, the direction of movement and/or the speed of said minority carriers are controlled by the extension of the potential minimum or by the majority carriers collected in said potential minimum, respectively, independently of the minority carriers on the other side of said potential minimum.

**2.** Semiconductor element according to Claim 1, **characterized** in that collector electrodes for said minority carriers are provided on each main surface (1, 2).

3. Semiconductor element according to Claim 1 or 2, **characterized** by at least one collector electrode (n + ) for said majority carriers.

4. Semiconductor element according to any of Claims 1 to 3, **characterized** in that the doping of the basic zone (k) in the area of at least one of said main surfaces (1, 2) is definedly modified so as to set the extension of the potential minimum (PM).

5. Semiconductor element according to any of Claim s 1 to 4 **characterized** in that the electrode array or part thereof is an insulating layer ($SiO_2$) on at least one of said main surfaces (1, 2), with a conductive layer (p...;R) having a defined surface resistance being applied on said insulating layer.

6. Semiconductor element according to Claim 5, **characterized** in that said conductive layer is a resistive layer.

7. Semiconductor element according to Claim 5, **characterized** in that said conductive layer is of the low-ohmic type.

8. Semiconductor element according to any of Claims 1 to 7, **characterized** in that said electrode array or part thereof is a depletion layer (P) having a defined surface resistance on at least one of said two main surfaces (1, 2).

9. Semiconductor element according to Claim 8, **characterized** in that the surface resistance is low-ohmic.

10. Semiconductor element according to Claim 8 or 9, **characterized** in that at least one zone of a second conductivity type cooperates with said basic zone so as to form said depletion layer.

11. Semiconductor element according to any of Claims 1 to 10, **characterized** in that a plurality of depletion layers and/or resistive/insulating/semiconductor structures, which are separated from each other, constitute said electrode array.

12. Semiconductor element according to any of Claims 1 to 11,

**characterized** in that said electrode arrays are disposed in a matrix or strip configuration.

13. Semiconductor element according to any of Claims 1 to 12, wherein an electrode array according to any of these claims is provided on one of the main surfaces, **characterized** in that on the other main surface a structure is provided which is adapted to be operated as minority carrier CCD in a manner known per se.

14. Semiconductor element according to any of Claims 12 or 13, **characterized** in that neutralizing electrodes are provided to extract the majority carriers between said strip- or matrix-shaped electrodes on said one main surface.

15. Semiconductor element according to any of Claims 12 or 13, **characterized** in that said electrode array on said one main surface consists of strips of a second conductivity type, with strips of the same conductivity type as that of the semiconductor body extending normal thereto in the main surface.

16. Semiconductor element according to any of Claims 12 to 15, **characterized** in that said strip-shaped or matrix-shaped structure on said one main surface consists of alternating resistive/insulating/semiconductor structures and depletion layers which are offset in the direction of the surface normal and in relation to one another.

17. Semiconductor element according to any of Claims 2 to 16, **characterized** in that the collector electrode for the majority carriers is a rise zone of the same conductivity type as that of said semiconductor body.

18. Semiconductor element according to any of Claims 2 to 17, **characterized** in that for a reduction of the capacitance of said collector electrode for the majority carriers a depletion zone of a conductivity type opposite to the conductivity type of said semiconductor body is disposed to join said collector electrode.

19. Semiconductor element according to Claim 18, **characterized** in that at least parts of said electrode array on at least one of the main surfaces include "trough-shaped" zones of a conductivity type opposite to the conductivity type of said semiconductor body.

20. Semiconductor element according to any of Claims 1 to 19, **characterized** in that said electrode array for the generation of the potential minimum for the majority carriers on at least one of the main surfaces serves at the same time as part of electronic elements and in particular as source and drain of field-effect transistors.

21. Semiconductor element according to any of Claims 1 to 20, **characterized** in that on at least one of the two main surfaces, amidst the electrode array, at least one zone is interposed which is part of an electronic device.

22. Semiconductor element according to any of Claims 1 to 21, **characterized** in that several potential minimums are provided by means of differently doped zones and/or hetero-structures in superimposed or juxtaposed relationship.

23. Semiconductor element according to Claim 21 or 22, **characterized** in that said majority and/or minority carrier signal is coupled by influence to said interposed zones.

## Revendications

1. Élément semiconducteur comprenant une région de base d'un type de conduction, qui porte des arrangements d'électrodes sur ses surfaces principales, à une tension de polarisation appliquée par au moins un desdits arrangements d'électrodes à au moins une surface principale de l'élément pour appauvrir ladite région de base complètement en porteurs majoritaires et pour établir un minimum de potentiel pour lesdits porteurs majoritaires, ledit minimum s'étendant, au moins en partie, à l'intérieur de ladite région de base, et dans lequel élément lesdits porteurs majoritaires sont collectés et transférables à au moins une électrode pour lesdits porteurs majoritaires, dans lequel sur au moins une surface principale est disposée au moins une électrode collecteur par laquelle les porteurs minoritaires le signal porteur minoritaire est lu, et dans lequel au moins de ce côté du minimum de potentiel pour les porteurs majoritaires sur lequel se trouve ladite électrode collecteur pour lesdits porteurs minoritaires, la quantité, la direction de mouvement et/ou la vitesse des porteurs minoritaires sont contrôlés par la variation du minimum de potentiel ou respectivement par les porteurs majoritaires collectés dans ledit minimum de potentiel, indépendamment des porteurs minoritaires de l'autre côté dudit minimum de potentiel.

2. Élément semiconducteur selon la Revendication 1, **caractérisé** en ce que des électrodes collecteurs (1, 2) pour des porteurs minoritaires sont disposés sur chaque surface principale.

3. Élément semiconducteur selon la Revendication 1 ou 2, **caractérisé** par au moins une électrode collecteur (n+) pour lesdits porteurs majoritaires.

4. Élément semiconducteur selon une quelconque des Revendications 1 à 3, **caractérisé** en ce que le dopage de ladite zone de base (k) dans la région d'au moins une des surfaces principales (1, 2) est modifié à définition d'une manière que la variation du minimum de potentiel (PM) soit ajustée.

5. Élément semiconducteur selon une quelconque des Revendications 1 à 4 **caractérisé** en ce que l'entier ou une partie de l'arrangement d'électrodes sur au moins une desdites surfaces principales (1, 2) est une couche isolante ($SiO_2$), une couche conductrice (p...;R) à résistivité superficielle définie étant appliquée sur ladite couche isolante.

6. Élément semiconducteur selon la Revendication 5, **caractérisé** en ce que ladite couche conductrice est une couche résistive.

7. Élément semiconducteur selon la Revendication 5, **caractérisé** en ce que ladite couche conductrice est de basse impédance.

8. Élément semiconducteur selon une quelconque des Revendications 1 à 7, **caractérisé** en ce que ledit arrangement d'électrodes ou une partie est une couche d'appauvrissement (P) à une résistivité superficielle définie sur au moins une desdites deux surfaces principales (1, 2).

9. Élément semiconducteur selon la Revendication 8, **caractérisé** en ce que la résistivité superficielle est de basse impédance.

10. Élément semiconducteur selon la Revendication 8 ou 9,
**caractérisé** en ce qu'au moins une zone d'un deuxième type de conduction coopère avec ladite zone de base en formant ladite couche d'appauvrissement.

11. Élément semiconducteur selon une quelconque des Revendications 1 à 10,
**caractérisé** en ce qu'une pluralité des couches d'appauvrissement et/ou des structures résistives/isolantes/semiconducteurs, qui sont séparées l'une de l'autre, forment ledit arrangement d'électrodes.

12. Élément semiconducteur selon une quelconque des Revendications 1 à 11,
**caractérisé** en ce que lesdits arrangements d'électrodes sont disposés en configuration à matrice ou à bandes.

13. Élément semiconducteur selon une quelconque des Revendications 1 à 12, dans lequel un arrangement d'électrodes selon une quelconque de cettes revendications est formé sur au moins une des surfaces principales,
**caractérisé** en ce que sur l'autre surface principale se trouve une structure qu'on peut agencer en tant qu'un porteur minoritaire CCD d'une façon connue en soi.

14. Élément semiconducteur selon une quelconque des Revendications 12 ou 13,
**caractérisé** en ce que des électrodes d'effacement sont formées pour extraire lesdits porteurs majoritaires entre lesdites électrodes en configuration à bandes ou à matrice sur ladite une surface principale.

15. Élément semiconducteur selon une quelconque des Revendications 12 ou 13,
**caractérisé** en ce que ledit arrangement d'électrodes sur ladite une surface principale est formés par des bandes d'un deuxième type de conduction, des bandes du même type de conduction que le type du corps semiconducteur s'y étendant perpendiculairement dans la surface principale.

16. Élément semiconducteur selon une quelconque des Revendications 12 à 15,
**caractérisé** en ce que ladite structure à configuration à bandes ou à matrice sur ladite une surface principale est formée en alternance par des structures résistives/isolantes/semiconducteurs et par des couches d'appauvrissement qui sont décalées dans la direction de la normale de surface et l'une relativement à l'autre.

17. Élément semiconducteur selon une quelconque des Revendications 2 à 16,
**caractérisé** en ce que l'électrode collecteur pour les porteurs majoritaires est une zone d'enrichissement du même type de conduction que le type dudit corps semiconducteur.

18. Élément semiconducteur selon une quelconque des Revendications 2 à 17,
**caractérisé** en ce qu'une zone d'appauvrissement d'un type de conduction opposé au type de conduction dudit corps semiconducteur est disposée à suivre ladite électrode collecteur, afin de réduire la capacité de ladite électrode collecteur pour les porteurs majoritaires.

19. Élément semiconducteur selon la Revendication 18,
**caractérisé** en ce que au moins des parties dudit arrangement d'électrodes sur au moins une des surfaces principales comprennent des zones "en forme de cuve" d'un type de conduction opposé au type de conduction dudit corps semiconducteur.

20. Élément semiconducteur selon une quelconque des Revendications 1 à 19,
**caractérisé** en ce que ledit arrangement d'électrodes pour créer le minimum de potentiel pour des porteurs majoritaires sur au moins une des surfaces principales présent, à même temps, la fonction d'une partie des éléments électroniques et en particulier la fonction de borne de source et de drain des transistors à effet de champ.

21. Élément semiconducteur selon une quelconque des Revendications 1 à 20,
**caractérisé** en ce que au moins une des deux surfaces principales, à l'intérieur de l'arrangement d'électrodes, est intercalée au moins une zone qui forme partie d'un élément électronique.

22. Élément semiconducteur selon une quelconque des Revendications 1 à 21,
**caractérisé** en ce que des zones à dopage différent et/ou des structures hétéro superposées ou côté à côté forment plusieurs minimums de potentiels.

23. Élément semiconducteur selon la Revendication 21 ou 22,
**caractérisé** en ce que le signal de porteurs majoritaires et/ou minoritaires est couplé à influence électrostatique audites zones interca-

lées.

Fig. 1

Fig. 2

Fig. 4

*Fig. 3a*

*Fig. 3b*

Fig. 5a

Fig. 5b

*Fig. 6*

Fig. 7

Fig. 8

EP 0 179 102 B1

Fig. 9

$Fig. 10$

FIG. 11

FIG. 12

FIG. 13a

FIG. 13b

FIG. 13c